Europäisches Patentamt

European Patent Office

Office européen des brevets

(19)

(11) **EP 1 610 461 A2**

(12) **EUROPEAN PATENT APPLICATION**

(43) Date of publication:
**28.12.2005 Bulletin 2005/52**

(51) Int Cl.7: **H03H 17/02**

(21) Application number: **05011656.5**

(22) Date of filing: **31.05.2005**

(84) Designated Contracting States:
**AT BE BG CH CY CZ DE DK EE ES FI FR GB GR
HU IE IS IT LI LT LU MC NL PL PT RO SE SI SK TR**
Designated Extension States:
**AL BA HR LV MK YU**

(30) Priority: **24.06.2004 US 876030**

(71) Applicant: **CIRRUS LOGIC INC.**
**Austin, Texas 78746 (US)**

(72) Inventor: **Chang, Yong Kang**
**Austin, Texas 78759 (US)**

(74) Representative: **Käck, Jürgen**
**Kahler Käck Mollekopf**
**Vorderer Anger 239**
**86899 Landsberg/Lech (DE)**

(54) **Digital adaptive hysteresis system**

(57)    An adaptive digital hysteresis technique where two modes are used to develop the output value, rather than the conventional single rounding technique, to reduce the quantization errors. To determine which of two different schemes, referred to as floor and ceil, to use, there are trip points to select modes. The floor and ceiling trip points are developed based on the value of the input signal. When the trip point for the other mode is exceeded and the next trip point for the current mode is not exceeded, the mode is changed. The output values of the technique have a lower error than the prior art rounding with hysteresis techniques.

Fig. 5

**Description**

Background of the Invention:

1. Field of the Invention

The invention generally relates to analog to digital conversion circuitry and more particularly to hysteresis techniques used in digital measurement systems.

2. Related Art

There are a number of digital audio media available today. This includes compact disks (CDs), digital audio tapes (DAT) and MP3s, to name the most common types. One problem with each of these media is that they use different sampling rates and thus different frequencies when providing audio data. It would be very expensive to build complete subsystems to handle each of the varying rates, so it has been common to use a device called a sample rate converter to transfer audio data from one digital sampling frequency rate to another. For example, a CD is sampled at 44.1 kHz while a DAT is sampled at 48 kHz. The backend of the system is to operate at only a single frequency, thus it is required to convert one of the signals to that desired frequency. For example, the DAT frequency sample rate of 48 kHz could be converted to a 44.1 kHz rate, which would then be utilized by a digital/analog converter system to provide the desired analog audio signal. Therefore, only a single set of backend circuitry would be required if the rates were converted to a common rate.

To this end, a number of sample rate converter integrated circuits have been developed which have the capability of converting between various input and output frequencies. An example of one of these is the Cirrus Logic CS8420. The basic operation of a sample rate converter is that the data is interpolated at an oversampling rate, then resampled at the desired output rate, and then decimated or filtered to produce the final resultant output. One of the requirements of this process is that the ratio between the input and output clocks be positively determined. For example, in the CS8420 there are 3 to 1 and I to 3 maximum ratios. Given this relatively limited ratio, the rate measurement circuitry was relatively simple to build. However, with the advent of the MP3 format and its high-end sampling frequency of 192 kHz, there is a requirement of a wider frequency ratio to be supported, such as approximately 8 to 1. The simple techniques used in the CS8420 to develop the frequency ratio would not be sufficient. In general, the problem developed because the ratio of the input and output frequencies was determined based on the digitization of the analog relationship between the two frequencies. Because of the digitization, quantization errors often appeared, as common in any analog to digital conversion process. Further, in some situations, it is also preferred that a hysteresis behavior be built into the quantization process to prevent the output value from frequently changing, thus enhancing the overall system stability. However, conventional hysteresis rules tend to increase the quantization error because any variation being held in the hysteresis region is basically additive to the quantization error. Given the increased ratio which is desired, the prior technique would have resulted in extremely large swings due to quantization and hysteresis errors as the ratios became large. These swings would have a deleterious effect on the output, so an improved technique is required.

Summary of the invention.

In an adaptive digital hysteresis technique according to the present invention, two modes are used to develop the output value, rather than the conventional single rounding technique, to reduce the quantization errors. To determine which of two different schemes, referred to as floor and ceiling modes, to use, it is necessary to have appropriate trip points to select modes. In various embodiments, the floor and ceiling trip points are developed based on the value of the input signal. For example, if the input signal exceeds a given amount, floor mode is used, while if it is below a given amount ceiling mode is used. If in a given mode, further data values are received that do not meet or exceed the other trip point, operation continues in the existing mode. When the trip point for the other mode is exceeded and the next trip point for the current mode is not exceeded, then the mode is changed. Thus, the output values of the technique have a lower output error as compared to prior art rounding with hysteresis techniques. This improved hysteresis technique results in a lower error frequency ratio value in a sample rate converter so that large ratios can be used.

Brief Description of the Figures.

The present invention has other advantages and features which will be more readily apparent from the following detailed description of the invention and the appended claims, when taken in conjunction with the accompanying drawings, in which:
Figure 1 is a block diagram of an exemplary system having multiple digital audio inputs, each of which has a different sampling rate, which is provided to a single rate conversion and output system.
Figure 2 is a block diagram of a sample rate converter of Fig. 1.
Figure 3 is a block diagram of the sample rate converter chip of Fig. 2.
Figure 4 is a block diagram of the rate estimator block of Fig. 3.
Figure 5 is a block diagram of the U/8 generator block of Fig. 4.

Detailed Description of the Preferred Embodiments.

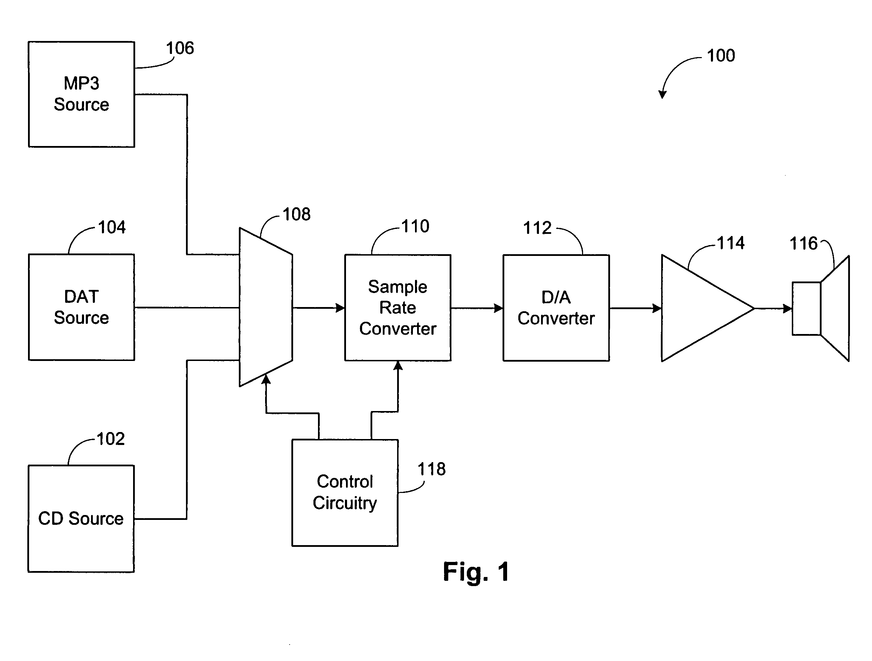

Figure 1 illustrates a simplified version of an exemplary audio system, which is capable of receiving signals from three digital audio sources and providing an audio output. For example, a first source is a Compact Disk (CD) source 102. A second source is a Digital Audio Tape (DAT) 104. The third illustrated source is an MP3 source 106. The CD source 102 will have the conventional CD sampling rate of 44.1 kHz, while the DAT source will have its conventional sampling rate of 48 kHz. An MP3 source may have many different sampling rates, but, in this example, an exemplary rate of 192 kHz is used. The outputs from each of these sources 102, 104 and 106 are provided as inputs to a multiplexer 108. The multiplexer 108 selects which of the sources are going to be provided to a sample rate converter 110. The sample rate converter 110 is used to convert the incoming digital audio signal at its rate into a digital audio signal at a different sampling rate. As an example, assume an output sample rate of 24 kHz from the sample rate converter 110. This output is a very low fidelity output given that the effective upper limit would be approximately 12 kHz but is one, which could be used in many environments as compared to the conventional upper limit of 20 kHz. These environments may include an automobile environment or a simple headset. The output of the sample rate converter 110 is provided to a digital to analog (D/A) converter 112. The output of the D/A converter 112 is provided to an amplifier 114, which, in turn, provides an output to a speaker 116 that outputs an audio signal. Control circuitry 118 is used to select the input of the multiplexer 108 and to provide the sample rate converter 110 with the desired input frequency and other particular setup parameters.

The above system is just one simple example for the purpose of illustrating embodiments according to the present invention. Variations are possible, such as different types or numbers of sources and different types of input or output. In other variations, the input and output are simple external connections for the source rate converter, with control settings to program the sample rate converter. One such example is used in professional audio equipment.

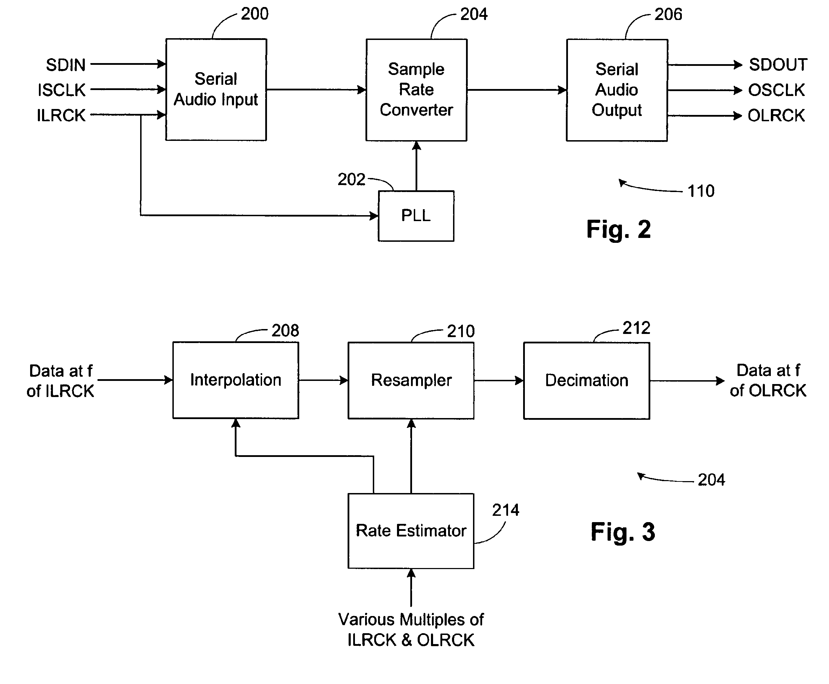

Figure 2 provides a more detailed block diagram of the sample rate converter 110. A serial audio input block 200 receives three signals. The SDIN or serial audio data input signal, the ISCLK or input serial audio bit clock signal and the ILRCK or input serial audio left/right clock signal. The ILRCK signal is also provided to a phased locked loop (PLL) 202. The PLL 202 generates a series of oversampled or multiplied versions of the ILRCK signal for use by a sample rate converter chip 204. The sample rate converter chip 204 receives the digital input signal from the serial audio input 200. The sample rate converter chip 204 provides its output signal to a serial audio output block 206. The output block 206 includes output signals of SDOUT, OSCLK and OLRCK.

The signals mean serial audio data output signal, output serial audio bit clock signal and output serial audio left/right clock signal. The left/right clock signals are the sampling rates for the respective input or output audio data.

Figure 3 provides a more detailed block diagram of the sample rate converter chip 204. Data is provided at the frequency of the ILRCK signal to an interpolation block 208. The interpolation block 208 provides an up-sampled output at a frequency multiple of the ILRCK signal. This output is provided to a resampler block 210. The resampler block 210 develops an analog signal from the signal provided by the interpolation block 208 and then samples this analog signal at a multiple of the desired output frequency. This digital output at the higher sampling rate is provided to a decimation block 212, which reduces the frequency of the data to the desired frequency. A rate estimator block 214 receives the various multiples of the IRLCK and OLRCK signals from the PLL 202 and provides signals to the interpolation block 208 and the resampler 210 block to allow the interpolation block 208 and resampler block 210 to properly up-sample the signal and resample the signal.

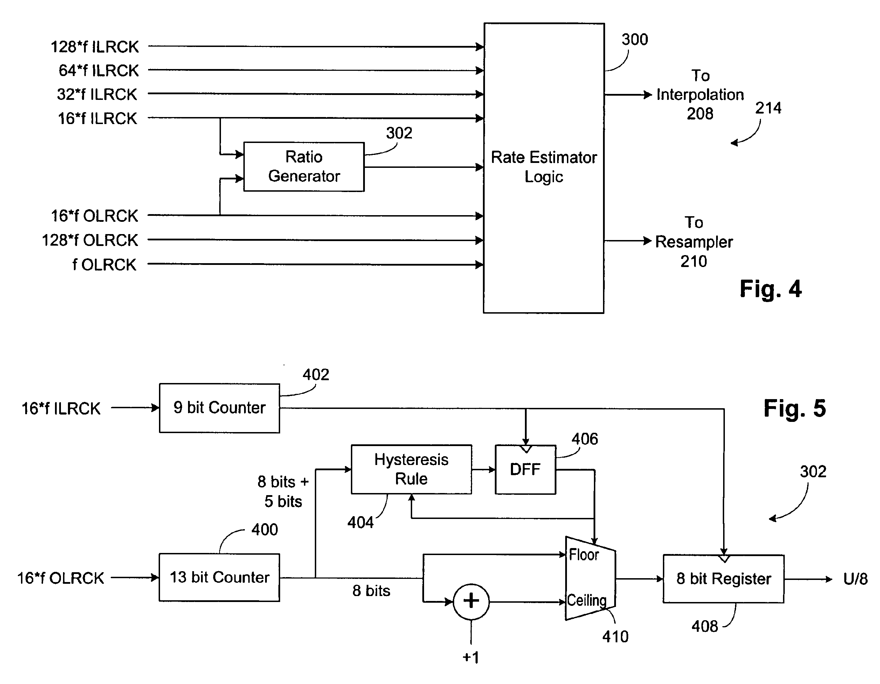

Figure 4 is a block diagram of the rate estimator block 214. As can be seen, a series of multiples of the ILRCK signal, preferably 16, 32, 64 and 128 times the input frequency, are provided to rate estimator logic 300. Additionally, signals that are preferably the frequency of the OLRCK signals and 16 times and 128 times the OLRCK frequency are also provided to rate estimator logic 300. The ratio generator 302 has an output signal to the rate estimator logic 300 which is a digital value representative of 16 times the ratio between the input frequency and output frequency signals. The rate estimator logic 300 uses this output signal from ratio generator 302 in combination with the other signals to provide properly timed signals to the interpolation block 208 and the resampler 210.

Figure 5 illustrates a detailed block diagram of the U/8 generator 302. The 16 times output frequency (16*f) or OLRCK signal is provided to a 13 bit counter 400. The 16 times input frequency (16*f) or ILRCK signal is provided to a 9-bit counter 402. The output of the 13-bit counter 400 is in two portions, an upper 8-bit portion and a lower 5-bit portion. The upper 8-bit portion and the lower 5-bit portion are provided to a hysteresis rule block 404, which operates according to the hysteresis technique described below. The output of the hysteresis rule block 404 is provided to a D flip-flop 406 which is clocked or triggered every time the counter 402 rolls over. The rollover signal is also provided to an 8-bit register 408 to latch an 8-bit value into this register 408.

The upper 8-bits of the 13-bit counter 400 are provided to a floor input of a two (2) input multiplexer 410. The 8-bit value is also provided to a one adder so that the 8-bit value plus 1 is provided as the second or ceiling (ceil) input of the multiplexer 410. Thus, the 8-bit value from the counter 400 or the 8-bit value plus one are the two potential outputs of the multiplexer 410. The selection of the particular input is based on the output of the D flip-flop 406, which indicates the hysteresis rule that is in effect. The output of the multiplexer 410 is provided to the input of the 8-bit register 408 so that each time the counter 402 rolls over, the upper 8-bits of the counter 400, or potentially one more based on the hysteresis rule, is loaded into the register 408. This value in the register 408 is used by the rate estimator logic 300 as the ratio of the input and output sample rates.

To discuss embodiments according to the hysteresis technique of the present invention, a review of the prior art hysteresis techniques is helpful. Assume that an analog quantity is being digitized into a fixed point number that has a certain number of bits below the radix point. The output of the system is an integer value without those fractional digits and is generated by rounding the value to the closest integer. When the original value is fluctuating around, say, 3.5, the output integer will also frequently switch between 3 and 4. To prevent this switching, it is necessary to build a hysteresis rule which may be prescribed as follows:

$$O[n+1] = Q[n], \text{ if } abs(O[n] - Q[n]) > 1$$
$$= O[n], \text{ otherwise}$$

where:

O[n] : output of the system at index n
M[n] : measured value at index n
Q[n] = round(M[n]) and

where the round function rounds positive numbers with a .5 fractional value or greater to the next highest integer and truncated otherwise.

The maximum output error with this scheme is (1.5 - delta). For example, if O[n] is 3, then the maximum M[n] is 4.4999.

Hysteresis techniques according to the present invention have two modes of operation:

Floor mode : O[n] = floor(M[n])
Ceiling mode :O[n] = ceil(M[n])

where the floor function rounds positive numbers with a fractional value to the truncated integer and the ceil function rounds positive numbers with a fractional value to the next higher integer. It is understood that the rounding can occur at other than integer values of significance if desired.

By properly switching between the two modes, the same hysteresis can be introduced with a smaller maximum error. Switching from one mode to another mode occurs when the M[n] value passes a trip point of the other mode. There are two trip points.

Floor trip point : M[n] = N + delta
Ceiling trip point: M[n] = N + 1 - delta

where N is an arbitrary integer that is the integer portion of M[n] and delta is the fractional value.

Switching from the ceiling mode to the floor mode occurs when the M[n] value reaches or passes the floor trip point from either direction. The same applies for the floor-to-ceiling mode switching.

The maximum output error with this scheme is (1 - delta). Typically, delta is set to the unit in last place or ulp of M[n]. The hysteresis range remains the same as M[n] changes values. In both schemes, the output is changed to a new value just by hitting the threshold, but it requires another change in M[n] equal to or greater than 1 to pass through the hysteresis region.

As an example, assume a delta value of 0.1 and an M[n] value of 5.1. Because this meets the floor trip point of 5.1 based on N=5 and delta = 0.1, floor mode is set and O[n] = 5. If the value of M[n+1] = 6.1, then the value is equal to the next floor trip point of 6.1 and floor mode is set, resulting in O[n + 1] = 6 due to the operation of floor mode. If M[n+1] is 5.7, then floor mode remains active and O[n+1] = 5. If M[n+1] is 4.5, then ceiling mode is entered since this value is past the ceiling mode trip point of 4.9 and then O[n+1] = 5. Now, if M[n+2] = 5.2, floor mode is entered since the value is past the floor mode trip point of 5.1 and O[n+2] = 5. If M[n+3]=6.2, then floor mode is still used but O[n+3] = 6.

With the circuit of Fig. 5, delta is $2^{-5}$ or 0.03125 based on the 5-bit fractional value of the 13-bit counter 400. If one assumes that U/8 must be greater than two for other reasons, then the lowest ceiling trip point is 2.96875 and the lowest floor trip point is 2.03125. Because of uncertainty in the last bit, the actual point may be 2.0625 so that the maximum down sample ratio is 16/2.0625 or 7.76, though the up sample ratio may be 8.

In some applications, such as those relating to specific sample rate conversion algorithms, there can be an additional requirement that O[n] must be smaller or greater than M[n]. For the simplicity of explanation, only the "smaller" case is discussed here. One possible prior art hysteresis rule for this case is:

$$O[n+1] = Q[n], \text{ if } abs(O[n] - Q[n]) > 1$$
$$= O[n], \text{ otherwise}$$

where Q[n] = floor(M[n]) - 2.

The "- 2" term in Q[n] instead of "- 1" is necessary because there is a case where O[n] = M[n] with Q[n] = floor(M[n]) - 1. As an example, when O[n] = 3 and M[n+1] = 3, then this situation leads to O[n+1] = M[n+1] = 3. With this scheme, the maximum output error is (4 - delta), for example, when O[n] = 3 and M[n+1]= 6.999. The hysteresis range is +/-2.

On the other hand, the hysteresis technique according to the present invention for this "smaller" case is as follows.

Floor mode : $O[n]$ = floor($M[n]$) - 1
Ceiling mode : $O[n]$ = ceil($M[n]$) - 1
Floor trip point : $M[n]$ = N + delta
Ceiling trip point: $M[n]$ = N + 1 - delta

The circuit of Figure 5 could be modified to accomplish this "smaller" case by removing the adder from the ceiling input of the multiplexer 410 and including a subtractor in the floor input.

The hysteresis technique according to the present invention for the "larger" case is as follows.

Floor mode : $O[n]$ = floor($M[n]$) + 1
Ceiling mode : $O[n]$ = ceil($M[n]$) + 1
Floor trip point : $M[n]$ = N + delta
Ceiling trip point: $M[n]$ = N + 1 - delta

The maximum output error with this scheme is also (2 - delta), with a hysteresis range of +/-1.

The circuit of Figure 5 could be modified to accomplish this "larger" case by having the ceiling input adder add two instead of one and by including an adder in the floor input.

Thus, a hysteresis technique is provided which improves the output of the sample rate converter by reducing errors in the measured input and output frequency ratio value due to quantization errors

While this hysteresis technique has been illustrated being used with a sample rate converter, it can be used other places where a lower output error is desired for a quantized value based on the conversion or measure of analog values.

Although the invention has been described in considerable detail with reference to certain embodiments, other embodiments are possible. As will be understood by those of skill in the art, the invention may be embodied in other specific forms without departing from the essential characteristics thereof. Accordingly, the present invention is intended to embrace all such alternatives, modifications and variations as fall within the spirit and scope of the appended claims and equivalents.

**Claims**

1. A method for developing a stable output value from a changing digital input signal, the method comprising:

setting a first trip point based on the value of the digital input signal;
setting a second trip point based on the value of the digital input signal;
setting and storing a mode state based on the value of the digital input signal, the previously stored mode state and said first and second trip points;
using a first output rounding method to produce the output value if the mode state is a first state; and
using a second output rounding method to produce the output value if the mode state is a second state.

2. The method of claim 1, wherein said first rounding method truncates and said second rounding method rounds upward.

3. The method of claim 2, wherein the rounding occurs to integer values.

4. The method of claim 1, wherein said first trip point is based on the truncated value of the digital input signal plus a constant and said second trip point is based on the rounded upward value of the digital input signal minus said constant.

5. The method of claim 4, wherein said constant has a value of the unit in last place of the digital input signal.

6. The method of claim 4, wherein said mode state changes state from a first state to a second state if the digital input signal value exceeds said second trip point, changes from said second state to said first state if the digital input signal value is less than the first trip point and otherwise does not change state.

7. The method of claim 1, wherein the output value must be smaller than the digital input signal and a constant is subtracted from the result of each rounding method.

8. The method of claim 1, wherein the output value must be larger than the digital input signal and a constant is added to the result of each rounding method.

9. A circuit for developing a stable output value from a changing digital input signal, the circuit comprising:

first trip point logic which sets a first trip point based on the value of the digital input signal;
second trip point logic which sets a second trip point based on the value of the digital input signal;
mode state storage logic;
mode state setting logic which sets the mode state based on the value of the digital input signal, the previously stored mode state and said first and second trip points; and
output rounding logic which uses a first output rounding method if the mode state is a first state and a second output rounding method if the mode state is a second state to produce the output value.

10. The circuit of claim 9, wherein said first rounding method truncates and said second rounding method rounds upward.

11. The circuit of claim 10, wherein the rounding occurs to integer values.

12. The circuit of claim 9, wherein said first trip point is based on the truncated value of the digital input signal plus a constant and said second trip point is based on the rounded upward value of the digital input signal minus said constant.

13. The circuit of claim 12, wherein said constant has a value of the unit in last place of the digital input signal.

14. The circuit of claim 12, wherein said mode state changes state from a first state to a second state if the digital input signal value exceeds said second trip point, changes from said second state to said first state if the digital input signal value is less than the first trip point and otherwise does not change state.

15. The circuit of claim 9, wherein the output value must be smaller than the digital input signal and said output rounding logic subtracts a constant from the result of each rounding method.

16. The circuit of claim 9, wherein the output value must be larger than the digital input signal and said output rounding logic adds a constant to the result of each rounding method.

17. An electronic device comprising:

    an input for receiving a changing digital input signal;
    an output for providing an output signal having an output value; and
    a circuit according to any of claims 9 to 16 which is connected to said input and said output.

18. An electronic device comprising:

    an input for receiving a changing input signal;
    an input logic element connected to said input to convert the input signal to a digital input signal;
    an output for providing an output signal having an output value; and
a circuit according to any of claims 9 to 16 which is connected to said input logic element and said output.

**Fig. 1**

EP 1 610 461 A2

EP 1 610 461 A2

**Fig. 2**

**Fig. 3**

EP 1 610 461 A2

128*f ILRCK

64*f ILRCK

32*f ILRCK

16*f ILRCK

Ratio Generator    302

Rate Estimator Logic    300

To Interpolation 208    214

16*f OLRCK

128*f OLRCK

f OLRCK

To Resampler 210

**Fig. 4**

16*f ILRCK → 9 bit Counter    402

**Fig. 5**

8 bits + 5 bits

Hysteresis Rule    404

DFF    406

302

16*f OLRCK → 13 bit Counter    400

8 bits

+1

Floor Ceiling    410

8 bit Register    408 → U/8